(19) Europäisches Patentamt
European Patent Office
Office européen des brevets

(11) Veröffentlichungsnummer: **0 068 414**
**A2**

# (12) EUROPÄISCHE PATENTANMELDUNG

(21) Anmeldenummer: **82105468.1**

(22) Anmeldetag: **22.06.82**

(51) Int. Cl.³: **H 01 L 21/312**, H 01 L 21/26

(30) Priorität: **26.06.81 DE 3125284**

(43) Veröffentlichungstag der Anmeldung: **05.01.83**
**Patentblatt 83/1**

(84) Benannte Vertragsstaaten: **AT DE FR GB IT**

(71) Anmelder: **SIEMENS AKTIENGESELLSCHAFT Berlin und München, Postfach 22 02 61, D-8000 München 22 (DE)**

(72) Erfinder: **Pammer, Erich, Dr., Platanenstrasse 59, D-8028 Taufkirchen (DE)**
Erfinder: **Niederle, Christl, Hofangerstrasse 47 d, D-8000 München 83 (DE)**
Erfinder: **Rubner, Roland, Dr., Dipl.-Chem., Buchenring 15, D-8551 Röttenbach (DE)**
Erfinder: **Ahne, Hellmut, Dr., Dipl.-Chem., Heidestrasse 6, D-8551 Röttenbach (DE)**

## (54) Verfahren zum Herstellen von Bauelementen aus Halbleiterscheiben.

(57) Die Erfindung betrifft ein Verfahren zur Herstellung von Bauelementen aus Halbleiterscheiben, bei dem mindestens die, aktive Elemente enthaltenden Bereiche (2) der Halbleiterscheiben (1) mit einer Kunststoffschicht (4) versehen werden. Die Halbleiterscheiben (1) werden mit einer aus einer fotovernetzbaren Vorstufe hochwärmebeständiger Polymere bestehenden Lackschicht (4) versehen, die Lackschicht (4) wird mit Ausnahme mindestens der Bereiche der Scheibenoberfläche (7), in denen Kontaktflächen (3) angeordnet sind, bestrahlt. Anschließend werden die unbestrahlten Anteile der Lackschicht (4) entfernt und die Halbleiterscheiben (1) getempert.

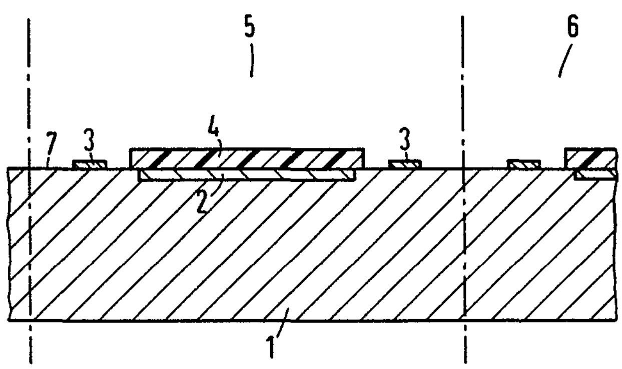


EP 0 068 414 A2

0068414

SIEMENS AKTIENGESELLSCHAFT
Berlin und München

Unser Zeichen
VPA 81 P 1083 E

Verfahren zur Herstellung von Bauelementen aus Halbleiterscheiben

Die Erfindung betrifft ein Verfahren zur Herstellung von Bauelementen aus Halbleiterscheiben, bei dem mindestens die, aktive Elemente enthaltenden Bereiche der Halbleiterscheiben mit einer Kunststoffschicht versehen werden.

Entsprechende Verfahren, bei denen die Halbleiterscheiben und damit die in späteren Verfahrensschritten aus den Halbleiterscheiben herausgetrennten Halbleiterchips mittels einer dünnen Silicon- oder Polyimidschicht bedeckt werden, sind z. B. aus Electronics, Sept. 11, 1980, S. 41, 42 bekannt. Die dünnen, die Halbleiterscheiben bedeckenden Kunststoffschichten sollen durch Alphastrahlung induzierte sogenannte "soft-error"-Ausfälle, die insbesondere bei hochintegrierten Schaltkreisen, beispielsweise dynamischen Halbleiterspeichern wie 64k RAM's (Random Access Memories) auftreten, verhindern. Die Alphastrahlung wird durch den natürlichen Anteil an radioaktiven, aus Thorium und Uran bestehenden Spurenverunreinigungen in den keramischen Gehäusen der Schaltkreise bzw. in den mineralischen Füllstoffen von Kunststoff-Verkapselungsmassen für Schaltkreise verursacht.

Die dünne Kunststoffschicht, die die Halbleiterchips bedeckt, verhindern solche "soft-error"-Ausfälle, da die Schicht die Energie der vom Füllstoff oder vom Keramikgehäuse kommenden Alphastrahlen hinreichend reduziert. Eine ganzflächige Abdeckung des Halbleiterchips ist jedoch problematisch, da sie sich negativ auf die Dichtigkeit der Bauelementgehäuse und die elektrische Stabilität

Nte 1 Gae / 22.06.81

der Bauelemente auswirken kann. Insbesondere führen die unterschiedlichen Ausdehnungskoeffizienten des Halbleitergrundmaterials (Silicium, Germanium oder eine III-V-Verbindung) und des bedeckenden Kunststoffs leicht zu Kontaktabrissen der den Halbleiterchip und die Anschlußstifte verbindenden Anschlüsse (Nailheads etc.).

Bedeckt man die Halbleiterscheiben bzw. die Halbleiterchips nicht ganzflächig mit einer Polyimidschicht, sondern strukturiert diese Schicht in der Weise, daß die auf den Chipoberflächen angeordneten Kontaktflächen, die in einem späteren Verfahrensschritt beispielsweise mittels einer Nailhead-Kontaktierung mit Drähten kontaktiert werden, frei von Polyimid sind, so muß eine zunächst noch nicht oder nur partiell zum Polyimid cyclisierte Vorstufe auf die Scheibenoberfläche gebracht werden, und anschliessend dann eine zusätzliche Fotolackschicht als Maske aufgebracht werden. Das Herauslösen der nichtmaskierten, zunächst noch nicht oder nur partiell zum Polyimid cyclisierten Polyimidvorstufenbereiche kann mit einem speziellen, den Fotolack nicht angreifenden Lösungsmittel erfolgen. Erst nach anschließendem Entfernen des Fotolacks in einem nur naßchemisch durchführbarem Ablöseprozeß kann durch nachfolgendes Tempern bei erhöhter Temperatur die Cyclisierung zu temperaturfestem Polyimid erfolgen. Ein solches Verfahren ist jedoch aufgrund der zahlreichen notwendigen Verfahrensschritte wirtschaftlich aufwendig.

Aufgabe der vorliegenden Erfindung ist es, hier Abhilfe zu schaffen und ein einfacheres und damit wirtschaftlich günstigeres Verfahren zur Herstellung von gegen Alphastrahlen unempfindlichen Bauelementen aus Halbleiterscheiben vorzusehen, bei dem mindestens die, aktive Elemente wie Transistoren, Dioden etc. enthaltenden Bereiche der Halbleiterscheiben mit einer temperaturfesten Kunststoffschicht versehen werden.

Diese Aufgabe wird erfindungsgemäß dadurch gelöst, daß die Halbleiterscheiben mit einer, aus einer fotovernetzbaren Vorstufe hochwärmebeständiger Polymere bestehenden Lackschicht versehen werden, daß die Lackschicht mit Ausnahme mindestens der Bereiche der Scheibenoberfläche, in denen Kontaktflächen angeordnet sind, bestrahlt wird, daß die unbestrahlten Anteile der Lackschicht entfernt werden und daß die Halbleiterscheiben anschließend getempert werden. Auf diese Weise gelingt es, ohne daß ein Fotolack aufgebracht und anschließend wieder entfernt werden muß, eine strukturierte temperaturfeste Kunststoffschicht auf der Halbleiterscheibenoberfläche aufzubringen.

Vorteilhafterweise wird eine gebrauchsfähige Lösung der fotovernetzbaren Polymerevorstufe verwendet, die bereits einen Haftvermittler enthält, da somit unter Einsparung von Prozeßschnitten auf eine üblicherweise notwendige Beschichtung des Substrates mit Haftvermittler und Trocknung desselben verzichtet werden kann.

Die Haftvermittler werden vorzugsweise mit zwischen 0,3 und 5, insbesondere zwischen 0,8 und 1,5 Masseprozent, bezogen auf den Festharzanteil der Harzlösung eingesetzt.

Als fotovernetzbare Vorstufen von Polymeren werden vorzugsweise solchen von Polymeren, ausgewählt aus den Stoffklassen der Polyisoindolchinazolindione, Polyamidimide, Polyesterimide, Poly-1,3-oxazin-6-one, Poly-1,3-chinazolin-2,6-dione, Polybenz-1,3-oxazindione-2,4- und insbesondere der Polyimide als Lackschicht verwendet.

Vorzugsweise wird die Dicke der aufgebrachten Lackschicht im Bereich von 100 bis 140 /um gewählt.

Ausgestaltungen des erfindungsgemäßen Verfahrens sind in Unteransprüchen gekennzeichnet.

Die Erfindung wird im Folgenden anhand der Fig. näher erläutert, die ausschnittsweise einen Schnitt durch eine mittels des erfindungsgemäßen Verfahrens hergestellte Halbleiterscheibe zeigt.

Die in der Fig. ausschnittsweise im Querschnitt gezeigte Halbleiterscheibe 1, z. B. eine Siliciumscheibe, weist eine Vielzahl von gleichartigen auf ihr integrierten Schaltungen auf, die in einem späteren Verfahrensschritt zu einzelnen Halbleiterchips 5,6 zertrennt werden. Der aktive Bereich 2, der die vor Alphastrahlen zu schützenden integrierten Schaltungsanordnungen, bei Halbleiterspeichern z. B. das sogenannte Zellenfeld enthält, ist in der Fig. schematisch angedeutet. Die Kontaktflächen 3 dienen zur späteren Drahtkontaktierung, um die integrierte Schaltung mit den Anschlußstiften des Gehäuses zu verbinden. Um diese Kontaktierung zu ermöglichen und um ein Abreißen der Kontaktierungsdrähte von den Kontaktflächen 3 zu verhindern, soll nach dem erfindungsgemäßen Verfahren die Polymerschicht 4 zumindest den gesamten aktiven, alphastrahlungs-empfindlichen Bereich 2, nicht aber die in der Regel aus Aluminium hergestellten Kontaktflächen 3 ("Aluminium-Pads") bedecken.

Im ersten Verfahrensschritt wird die gesamte Oberfläche 7 der Halbleiterscheibe 1 mit einer, aus einer fotovernetzbaren Vorstufe hochwärmebeständiger Polymere bestehenden Lackschicht versehen. Es können vorteilhafterweise fotovernetzbare Vorstufen folgender Polymere verwendet werden:

Polyisoindolchinazolindione, Polyimide, Polyamidimide, Poly-1,3-oxazin-6-one, Poly-1,3-chinazolin-2,6-dione Polybenz-1,3-oxazindione-2,4 und Polyesterimide.

Insbesondere hat sich der Einsatz fotovernetzbarer Polyimidvorstufen bewährt.

Die Herstellung entsprechender Vorstufen, ihre fotochemische Strukturierung und anschließende thermische Stabilisierung ist aus der DE-PS 23 08 830, die ein Verfahren zur Herstellung von Reliefstrukturen aus hochwärmebeständigen Polymeren durch Auftragen strahlungsempfindlicher löslicher polymerer Vorstufen in Form einer Schicht oder Folie auf ein Substrat, Bestrahlen der strahlungsempfindlichen Schicht oder Folie durch Negativvorlagen, Herauslösen oder Abziehen der nicht bestrahlten Schicht- oder Folienteile und gegebenenfalls anschließendes Tempern der erhaltenen Reliefstrukturen, bei dem als lösliche polymere Vorstufen Polyadditions- oder Polykondensationsprodukte polyfunktioneller carbocyclischer oder heterocyclischer, strahlungsempfindliche Reste tragender Verbindungen mit Diaminen, Diisocyanaten, Bis-säurechloriden oder Dicarbonsäuren verwendet werden, wobei

a) die strahlungsempfindliche Reste $R^*$ tragende Verbindungen zwei für Additions- oder Kondensationsreaktionen geeignete Carboxyl-, Carbonsäurechlorid-, Amino-, Isocyanat- oder Hydroxylgruppe und teilweise in ortho- oder peri-Stellung dazu erstartig an Carboxylgruppen gebundene strahlungsaktive Gruppen der folgenden Struktur 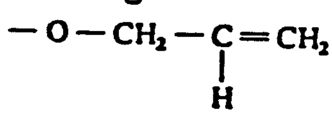

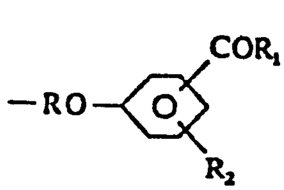

R = Oxyalkyl

$R_1$ = Alkyl, Phenyl, Alkoxyphenyl, Halogenphenyl

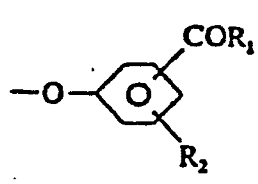

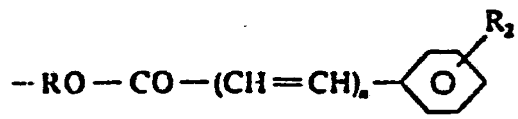

$n = 1,2$

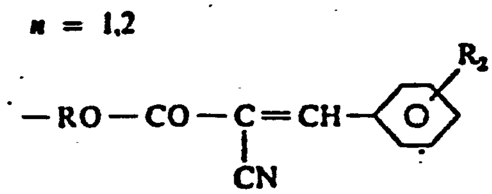

$R_2$ = H, Cl, Alkyl, Alkoxy

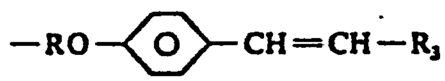

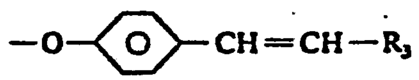

$R_3$ = carbocycl. oder heterocycl. aromat. Rest, über Ring-C gebunden

enthalten und wobei

b) die mit diesen Verbindungen umzusetzenden Diamine, Diisocyanate, Bis-säurechloride oder Dicarbonsäuren mindestens ein cyclisches Strukturelement enthalten, betrifft, bekannt.

Weitere Polymere, die durch Erwärmen unter Abspaltung der strahlungsempfindlichen Reste $R^*$ zu neuen heterocyclischen Kettengliedern cyclisierbar sind, und in Form einer Schicht auf einem Substrat durch Negativvorlagen belichtet oder bestrahlt werden, sind ferner aus der DE-PS 24 37 348 und der DE-PS 24 62 105 bekannt.

Die fotovernetzbaren Vorstufen der hochwärmeständigen Polymere, beispielsweise eines Polyimides, werden in möglichst gleichmäßiger Dicke auf die gesamte Oberfläche 7 der Halbleiterscheibe 1 aufgetragen. Dies kann z. B. mittels einer s. g. Spin-Beschichtung geschehen, bei der

die Halbleiterscheibe 1 auf einen, auf einer drehbaren Achse angeordneten Teller gebracht wird, in Scheibenmitte ein Tropfen des Beschichtungsmittels aufgebracht und anschließend durch Zentrifugalkraft auf der ganzen Scheibe 1 verteilt wird.

Ein weiteres Beschichtungsverfahren zur Beschichtung der Halbleiterscheibe 1 mittels einer Schicht 4, z. B. einer Polyimidvorstufe, ist das Roller-Verfahren, bei dem die Halbleiterscheibe 1 zwischen zwei Walzen, von denen eine in ein, mit der flüssigen Polymidvorstufe gefülltes Bad eintaucht, auf einer Unterlage durchgeführt und damit einseitig beschichtet wird. Es ist auch möglich, eine sogenannte Curtain-Beschichtung vorzunehmen, bei der die Halbleiterscheiben 1 auf einem Fließband angeordnet sind, das unter einem als Düse wirkenden schmalen Schlitz, der von oben aus einer die Beschichtungsflüssigkeit enthaltenden Wanne mit Flüssigkeit versorgt wird, vorbei bewegt werden.

Die aus der fotovernetzbaren Vorstufe hochwärmebeständiger Polymere bestehende Lackschicht 4 hat vorteilhafterweise eine Dicke von 100 bis 140 /um.

Nach kurzem Trocknen kann die so behandelte Halbleiterscheibe 1 unmittelbar der Belichtung und Strukturentwicklung unterzogen werden. Dies kann z. B. in der Weise geschehen, daß die Vorstufenschicht 4 dem bekannten, bei Negativlacken angewandten Verfahren entsprechend, mit einer Maske bedeckt und dann mit einer energiereichen Strahlungsart, vorzugsweise UV-Licht, in der Weise bestrahlt wird, daß nur der Bereich 2 der Scheibenoberfläche 7, in dem aktive Elemente angeordnet sind, bestrahlt wird. Die unbelichteten oder nichtbestrahlten Anteile werden in an sich bekannter Weise anschließend z. B mittels eines Lösungsmittels herausgelöst

oder abgezogen.

Damit wird die in der Fig. gezeigte kantenscharfe Reliefstruktur erhalten, bei der nur der aktive Bereich 2 von der schützenden Polymerschicht 4 bedeckt ist, die Kontaktflächen 3 jedoch frei bleiben.

In einem abschließenden Verfahrensschritt werden die so behandelten Halbleiterscheiben 1 kurzzeitig zwischen 20 und 80 Min., insbesondere 30 Min., lang bei Temperaturen von vorzugsweise 150 - 500° C, insbesondere 350 - 450° C getempert. Durch die Temperung wird eine chemische Umwandlung zu einer hochtemperaturfesten Polymerschicht 4 erreicht, die in etwa die Hälfte der Dicke der ursprünglich aufgebrachten Lackschicht aufweist. Beim Einsatz fotovernetzbarer Polyimidvorstufen hat es sich als vorteilhaft erwiesen, von einer in etwa 120 $\mu$m dicken Lackschicht auszugehen, diese nach kurzem Trocknen unmittelbar der Belichtung und Strukturentwicklung zu unterziehen und durch anschließendes Erhitzen für je 30 Min. auf 275 und 400° C in eine hochtemperaturfeste Polyimidschicht von etwa 60 $\mu$m Dicke umzuwandeln.

Anschließend an das erfindungsgemäße Verfahren kann in an sich bekannter Weise die Trennung der Chips 5, 6 und ihre weitere Montage erfolgen.

Enthält die fotosensitive Lackschicht 4 auch Substanzen, die die Haftung und die Benetzung auf der Oberfläche der Scheibe 1 verbessern (Haftvermittler), so können im Vergleich zum Stand der Technik weitere Prozeßschritte eingespart werden. Geeignete Haftvermittler sind insbesondere Silane, z. B. :
Vinyltriethoxysilan, Vinyltri(methoxyethoxy)silan, Vinyltrimethoxysilan, $\gamma$ -Methacryloxypropyltrimethoxysilan und $\gamma$ -Glycidoxypropyltrimethoxysilan, die zwischen

0,3 und 5 Masseprozent, bezogen auf den Festharzanteil der Harzlösung, eingesetzt werden können.

Wird -wie in der Regel üblich- auf die die aktiven Bereiche 2 enthaltende Oberfläche der Scheiben 1 eine schützende Isolierschicht, insbesondere eine quarzähnliche Lackschicht aus $SiN_3$, vor dem Aufbringen der fotosensitiven Lackschicht 4 aufgebracht, so muß diese Isolierschicht z. B. mittels einer Fototechnik an den Kontaktflächen 3 entfernt werden um eine Kontaktierung zu ermöglichen.

Durch ganzflächiges Aufbringen der fotosensitiven Lackschicht 4 auf dieser Oberfläche der Scheiben 1 und entsprechende Strukturierung der Lackschicht 4 (anschließendes Freibleiben der Bereiche der Kontaktflächen 3) entfällt die Verwendung spezieller Masken o.ä. zur Entfernung der Isolierschicht an den Kontaktflächen 3.

1 Figur
11 Patentansprüche

Patentansprüche

1. Verfahren zur Herstellung von Bauelementen aus Halbleiterscheiben, bei dem mindestens die, aktive Elemente enthaltenden Bereiche (2) der Halbleiterscheiben (1) mit einer Kunststoffschicht (4) versehen werden, d a d u r c h g e k e n n z e i c h n e t, daß die Halbleiterscheiben (1) mit einer, aus einer fotovernetzbaren Vorstufe hochwärmebeständiger Polymere bestehenden Lackschicht (4) versehen werden, daß die Lackschicht (4) mit Ausnahme mindestens der Bereiche der Scheibenoberfläche (7), in denen Kontaktflächen (3) angeordnet sind, bestrahlt wird, daß die unbestrahlten Anteile der Lackschicht (4) entfernt werden und daß die Halbleiterscheiben (1) anschließend getempert werden.

2. Verfahren nach Anspruch 1, d a d u r c h g e k e n n z e i c h n e t, daß der fotovernetzbaren Vorstufe hochwärmebeständiger Polymere mindestens ein Haftvermittler zugemischt wird.

3. Verfahren nach Anspruch 2, d a d u r c h g e k e n n z e i c h n e t, daß der prozentuale Anteil des Haftvermittlers im Bereich zwischen 0,3 und 5 % gewählt wird.

4. Verfahren nach Anspruch 2, d a d u r c h g e k e n n z e i c h n e t, daß der prozentuale Anteil des Haftvermittlers im Bereich zwischen 0,8 und 1,5 % gewählt wird.

5. Verfahren nach einem der Ansprüche 1 bis 4, d a d u r c h g e k e n n z e i c h n e t, daß fotovernetzbare Vorstufen von Polymeren ausgewählt aus den Stoffklassen der Polyisoindolchinazolindione, Polyimide, Polyamidimide, Polyesterimide, Poly-1,3-oxazin-6-one,

Poly-1,3-chinazolin-2,6-dione und Polybenz-1,3-oxazindione-2,4, als Lackschicht (4) verwendet werden.

6. Verfahren nach einem der Ansprüche 1 bis 5, dadurch gekennzeichnet, daß fotovernetzbare Vorstufen von Polyimiden als Lackschicht (4) verwendet werden.

7. Verfahren nach einem der Ansprüche 1 bis 6, dadurch gekennzeichnet, daß die Dicke der Lackschicht (4) im Bereich von 100 bis 140 µm gewählt wird.

8. Verfahren nach einem der Ansprüche 1 bis 7, dadurch gekennzeichnet, daß nur der Bereich (2) der Scheibenoberfläche (7), in dem aktive Elemente angeordnet sind, bestrahlt wird.

9. Verfahren nach einem der Ansprüche 1 bis 8, dadurch gekennzeichnet, daß die Bestrahlung mit UV-Licht erfolgt.

10. Verfahren nach einem der Ansprüche 1 bis 9, dadurch gekennzeichnet, daß die Halbleiterscheiben (1) 20 bis 80 Min. bei einer Temperatur von 150 bis 500° C getempert werden.

11. Verfahren nach einem der Ansprüche 1 bis 10, dadurch gekennzeichnet, daß die Lackschicht (4) ganzflächig auf die Oberfläche der Halbleiterscheiben (1) aufgebracht wird.

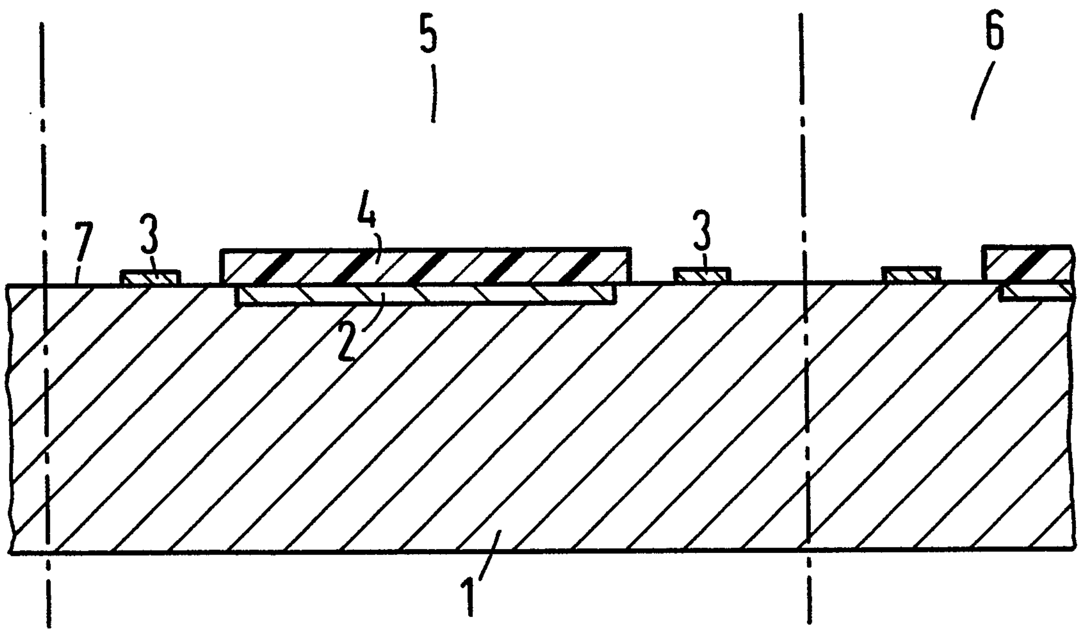
5
6
7
3
4
3
2
1